# EUROPEAN PATENT APPLICATION

(11) **EP 4 583 400 A1**
(43) Date of publication of application: **09.07.2025**
(21) Application number: 24215616.4
(22) Date of filing: 27.11.2024
(51) Int. Cl.: H02S 40/30, H02S 40/38, H10F 77/00

(54) **REGULATING HIGH-VOLTAGE BUSES WITH PARTITIONED SETS OF SOLAR CELLS**

(30) Priority: 02.01.2024 US 202418402450
(71) Applicant: The Boeing Company, Arlington, VA 22202 (US)
(72) Inventor: WHITE, Bryan L., Arlington, 22202 (US)
(74) Representative: Morrall, Jonathan Ian McLachlan

(57) **Abstract**

One example provides a solar device comprising one or more solar arrays. The one or more solar arrays comprises a low-voltage set of solar cells and a high-voltage set of solar cells. The solar device further comprises a low-voltage bus connected to the low-voltage set of solar cells, a high-voltage bus connected to the high-voltage set of solar cells, a low-voltage battery connected to the low-voltage bus, a high-voltage battery connected to the high-voltage bus, and a switch connected between the low-voltage battery and an input of the high-voltage set of solar cells.

## Description

### FIELD

The disclosed examples relate to solar devices that provide electric power for both low-voltage and high-voltage onboard electronics.

### BACKGROUND

Solar devices can use arrays of solar cells ("solar arrays") to provide electric power to various onboard electronics. For example, a satellite can utilize a battery-on-bus power system to manage the electric power produced by a solar array. Such power systems extract electric power from the solar arrays, when illuminated, to power the electronics and/or charge the battery. Further, the battery can power the electronics when the solar arrays are not illuminated.

### SUMMARY

One example provides a solar device comprising one or more solar arrays. The one or more solar arrays comprises a low-voltage set of solar cells and a high-voltage set of solar cells. The solar device further comprises a low-voltage bus connected to the low-voltage set of solar cells, a high-voltage bus connected to the high-voltage set of solar cells, a low-voltage battery connected to the low-voltage bus, a high-voltage battery connected to the high-voltage bus, and a switch connected between the low-voltage battery and an input of the high-voltage set of solar cells.

### BRIEF DESCRIPTION OF THE DRAWINGS

FIG. 1 schematically shows an example vehicle in the form of a satellite.
FIG. 2 illustrates a block diagram of an example solar device with low-voltage and high-voltage batteries.
FIGS. 3-4 illustrate block diagrams of example configurations for solar arrays of the solar device in FIG. 2.
FIG. 5 depicts a diagram of an example circuit for use with the solar device of FIG. 2.
FIGS. 6-7 schematically depict example electric current diagrams for the circuit of FIG. 5.
FIG. 8 schematically depicts another example solar device.
FIG. 9 illustrates a block diagram of an example high-voltage set of solar cells for selecting different rates of electric current.
FIG. 10 depicts a diagram of an example circuit utilizing the high-voltage set of solar cells of FIG. 9.
FIG. 11 illustrates a flow diagram of an example method for charging low-voltage and high-voltage batteries on a solar device.

### DETAILED DESCRIPTION

As previously mentioned, a satellite can utilize a battery-on-bus power system to manage electric power extracted from solar arrays. Some satellites utilize both a low-voltage battery and a high-voltage battery to power various electronics. As used herein, the term "high-voltage" is used to indicate that a voltage output by the corresponding electronic component or used by the corresponding electronic component is higher than a similar electronic component modified with the term "low-voltage." However, a low-voltage battery-on-bus power system can be inefficient at providing large amounts of electric power, as it may be difficult for such power systems to provide sufficient current to support the large amounts of electric power. To address this issue, a high-voltage battery-on-bus power system can be used with an integrated power controller or a converter component to connect to the low-voltage battery-on-bus power system. However, integrated power controllers and converter components can have complex circuitry and add manufacturing costs to the satellite and thus, may be undesirable.

Accordingly, examples are disclosed that relate to using a switch on a low-voltage bus to regulate a high-voltage bus on a solar device. As used herein, the term "switch" refers to a device having a first mode that creates an electrical connection, and a second mode that breaks the electrical connection. Briefly, a solar device comprises one or more solar arrays including a low-voltage set of solar cells and a high-voltage set of solar cells. A low-voltage bus is connected to the low-voltage set of solar cells and a low-voltage battery. A high-voltage bus is connected to the high-voltage set of solar cells and a high-voltage battery. In some examples, the high-voltage bus and the high-voltage battery have a voltage of 100 volts, and the low-voltage bus and the low-voltage battery have a voltage of 30 volts. In other examples, the low-voltage battery and bus may have another voltage. Further, in such examples, the high-voltage battery bus can have any suitable voltage that is higher than the voltage of the low-voltage battery and bus. The solar device further comprises a switch connected between the low-voltage battery and an input of the high-voltage set of solar cells. The switch is controllable to selectively connect the high-voltage set of solar cells electrically in series with the low-voltage set of solar cells. Therefore, the high-voltage set of solar cells can provide a voltage at the high-voltage bus that is higher than a voltage at the low-voltage bus. The switch and the high-voltage set of solar cells enable regulation of the high-voltage bus on the solar device that is less complex and costs less than solutions using integrated power controllers and/or converter components. The disclosed solar devices can be used in land environments, aerial environments, space environments, near-space environments, and/or marine environments. Example solar devices include satellites, unmanned vehicles, remote terrestrial sensing/communication devices, and extra-terrestrial sensing/communication devices.

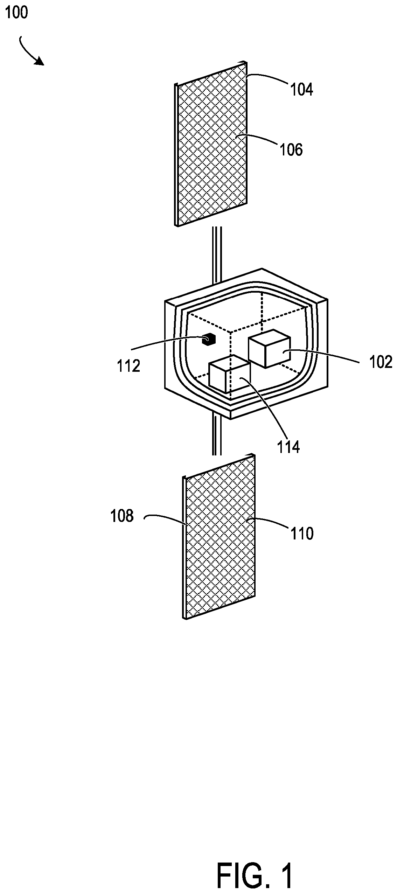

FIG. 1 schematically depicts an example vehicle 100 in the form of a satellite having flight electronics and payload electronics. Vehicle 100 comprises a low-voltage battery 102 to help power the flight electronics. Further, a first solar array 104 includes a low-voltage set of solar cells 106 configured to provide electric power to selectively charge low-voltage battery 102 and/or help to power the flight electronics, when illuminated. The payload electronics support a mission of vehicle 100, such as communications and/or remote sensing missions. The payload electronics use a voltage that is higher than a voltage of the low-voltage battery 102. As such, vehicle 100 further comprises a second solar array 108 including a high-voltage set of solar cells 110. Further, a switch 112 is configured to selectively connect high-voltage set of solar cells 110 electrically in series with low-voltage set of solar cells 106 to thereby charge a high-voltage battery 114 based upon a mission stage of vehicle 100 and/or electric charge of high-voltage battery 114. While discussed in terms of a vehicle, a switch controllable to selectively connect a high-voltage set of solar cells electrically in series with a low-voltage set of solar cells can be used for high-voltage bus regulation in other solar devices.

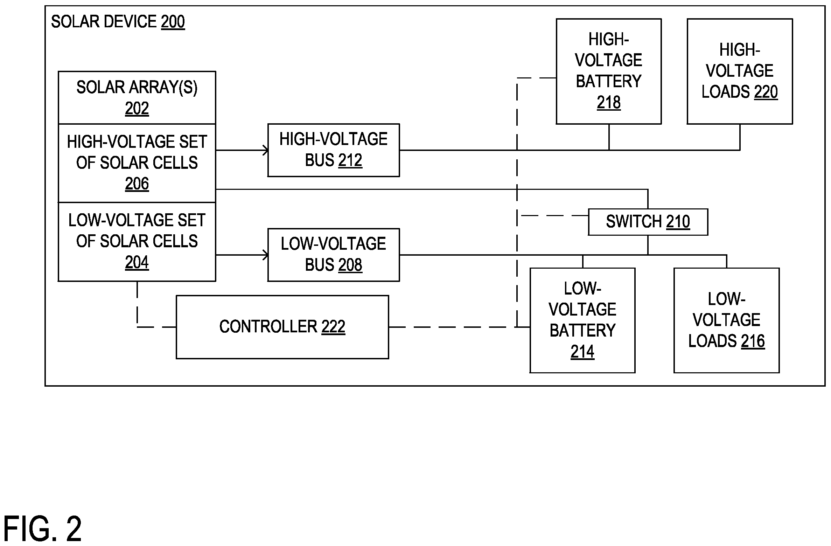

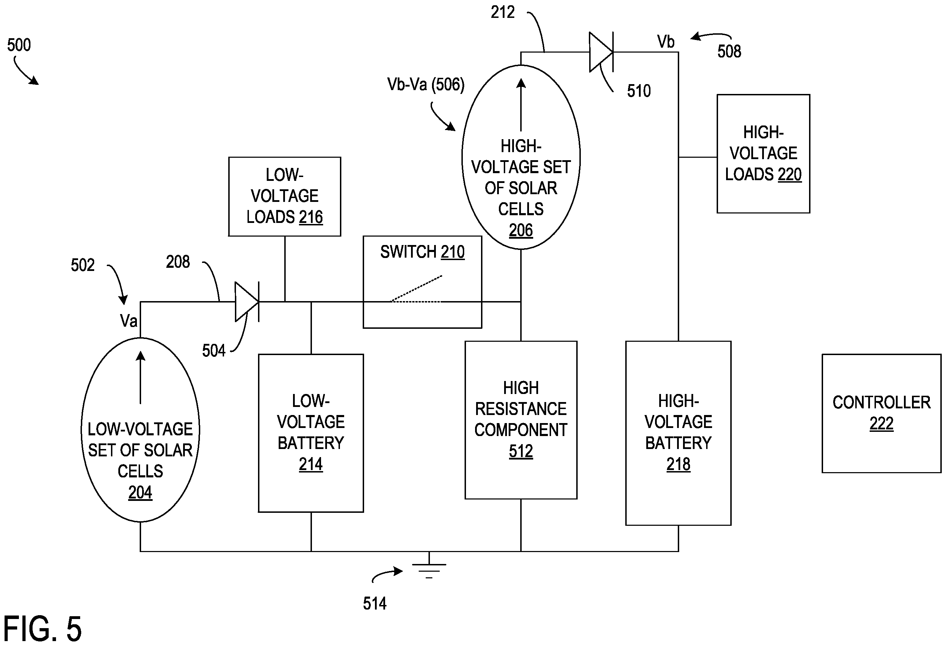

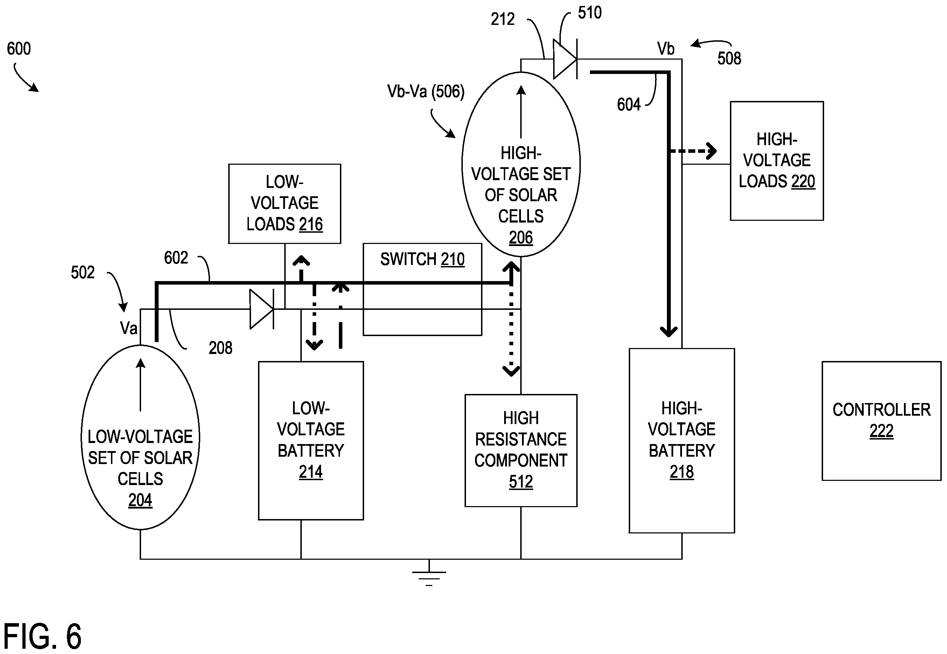

FIG. 2 illustrates a block diagram of an example solar device 200. Vehicle 100 is an example of solar device 200. Other examples of solar device 200 include unmanned vehicles and remote sensing/communication devices configured to operate in aerial environments, marine environments, terrestrial environments, extra-terrestrial environments, and/or space/near-spear environments. Solar device 200 comprises one or more solar arrays 202 that extract electric power when illuminated. The one or more solar arrays 202 includes a low-voltage set of solar cells 204 and a high-voltage set of solar cells 206. Further, a low-voltage bus 208 is connected to low-voltage set of solar cells 204, and to a switch 210 that is also connected to an input of high-voltage set of solar cells 206. Switch 210 is controllable to selectively connect high-voltage set of solar cells 206 to low-voltage bus 208. This enables high-voltage set of solar cells 206 to provide a voltage at a high-voltage bus 212 that is higher than a voltage at low-voltage bus 208, as discussed in more detail with reference to FIGS. 5 and 6.

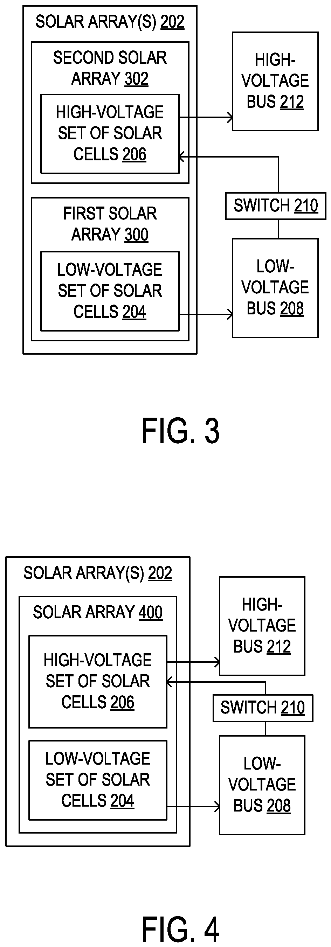

In some examples, the one or more solar arrays 202 comprises a first solar array 300 including low-voltage set of solar cells 204, and a second solar array 302 including high-voltage set of solar cells 206 as depicted in FIG. 3. In other examples, the one or more solar arrays 202 comprises a solar array 400 that is partitioned into low-voltage set of solar cells 204 and high-voltage set of solar cells 206, as depicted in FIG. 4. This can enable an existing solar array of a solar device to be modified without significant hardware changes to the solar device. In further examples, the one or more solar arrays 202 can have another configuration.

Returning to FIG. 2, solar device 200 further comprises a low-voltage battery 214 connected to low-voltage bus 208 and switch 210. Further, low-voltage loads 216 are also connected to low-voltage bus 208 to selectively receive electric power. Solar device 200 also comprises a high-voltage battery 218 and high-voltage loads 220 that are connected to high-voltage bus 212. Each of high-voltage battery 218 and high-voltage loads 220 (e.g., payload electronics) is controllable to selectively receive electric power, as discussed with reference to FIGS. 5 and 6. In other examples, a solar device can include an additional switch to selectively connect an additional set of solar cells electrically in series with high-voltage set of solar cells 206 to add another voltage bus at a higher voltage than the voltage of high-voltage bus 212. In further examples, solar device 200 can have additional low-voltage batteries and/or high-voltage batteries.

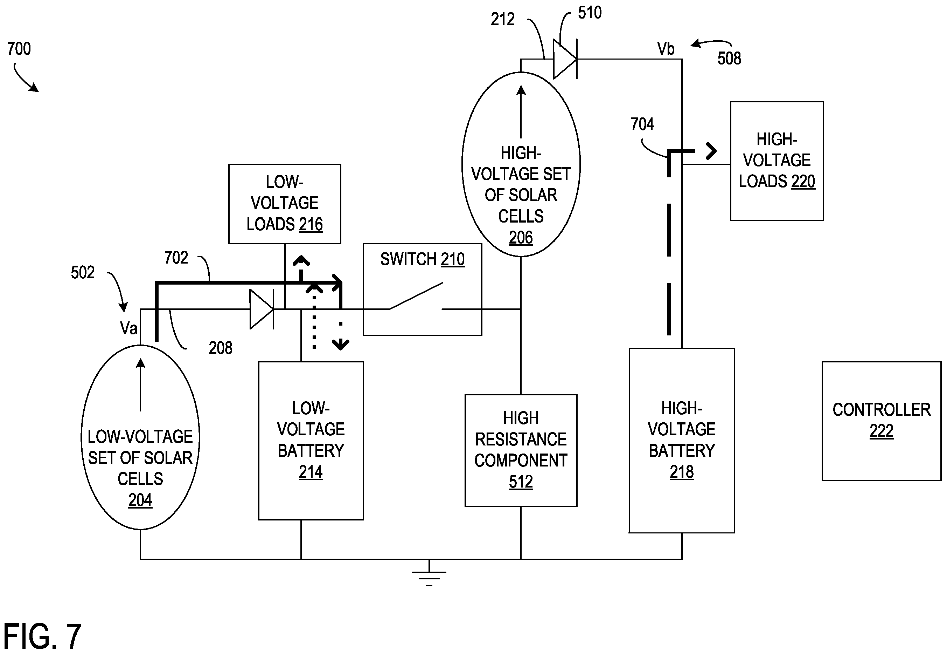

A controller 222 is configured to control switch 210 for regulation of high-voltage bus 212. More specifically, controller 222 is configured to control switch 210 to connect low-voltage bus 208 to an input of high-voltage set of solar cells 206. Therefore, switch 210 can connect high-voltage set of solar cells 206 electrically in series with low-voltage bus 208 to thereby charge high-voltage battery 218. Controller 222 further is configured to stop charging high-voltage battery 218 by controlling switch 210 to break the connection between high-voltage set of solar cells 206 and low-voltage bus 208, as discussed with reference to FIG. 7. Controller 222 can control switch 210 based at least upon electric charge of high-voltage battery 218. Alternatively or additionally, controller 222 can further control switch 210 based upon one or more of an operation mode of solar device 200, electric power extraction from the one or more solar arrays 202, electric charge of low-voltage battery 214, electric demands of low-voltage loads 216 and/or high-voltage loads 220, or in another suitable manner. In some examples, controller 222 can control other operations of solar device 200, such as electric load management, battery management, and/or electric power extraction, for example.

In such a manner, solar device 200 utilizes switch 210 to regulate a first battery-on-bus system of low-voltage battery 214 on low-voltage bus 208 and a second battery-on-bus system of high-voltage battery 218 on high-voltage bus 212. Further, this regulation can be performed without significant additional hardware (e.g., an integrated power controller) and thus help to reduce costs for solar device 200.

FIG. 5 illustrates an example circuit 500 utilizing switch 210 to regulate high-voltage bus 212. In circuit 500, low-voltage set of solar cells 204 selectively provides a first voltage 502 (Va) at low-voltage bus 208. A first diode 504 is connected to low-voltage set of solar cells 204 to help block possible reverse current flowing into low-voltage set of solar cells 204. As depicted, high-voltage set of solar cells 206 extracts a second voltage 506 (Vb-Va). As discussed in more detail with reference to FIG. 6, when high-voltage set of solar cells 206 is connected electrically in series with low-voltage set of solar cells 204, high-voltage set of solar cells 206 is configured to combine second voltage 506 with first voltage 502 to provide a third voltage 508 (Vb) at high-voltage bus 212. Additionally, a second diode 510 is connected to high-voltage set of solar cells 206 to help block possible reverse current flowing into high-voltage set of solar cells 206. Further, the electrical connection between high-voltage set of solar cells 206 and low-voltage set of solar cells 204 can be selective broken by switch 210 as discussed with reference to FIG. 7.

Circuit 500 comprises a high resistance component 512. In some examples, high resistance component 512 is configured to have a resistance that is orders of magnitude higher than a resistance of high-voltage set of solar cells 206. In some examples, high resistance component 512 comprises a resistance on the order of 100 kiloohms. In such a configuration, high resistance component 512 can help to prevent accidental charging of high-voltage battery 218 and/or provide isolation of a return node of high-voltage set of solar cells 206 from other return nodes (e.g., a return node of low-voltage set of solar cells 204 and/or a return node of solar device 200). Circuit 500 also comprises an electric ground 514 as part of a return path to low-voltage set of solar cells 204. In some examples, electric ground 514 comprises a device ground of solar device 200, such as a chassis of solar device 200, for example. FIG. 5 is illustrative. In other examples, circuit 500 can have another configuration.

FIGS. 6 and 7 schematically depict example current diagrams for circuit 500. First, FIG. 6 schematically illustrates an example current diagram 600 for charging high-voltage battery 218 in circuit 500. As can be seen, controller 222 controls switch 210 to electrically connect low-voltage bus 208 to the input of high-voltage set of solar cells 206 to thereby connect high-voltage set of solar cells 206 electrically in series with low-voltage set of solar cells 204. As such, first electric current 602 flows from low-voltage set of solar cells 204 to the input of high-voltage set of solar cells 206. Further, as high-voltage set of solar cells 206 receives first electric current 602 and when illuminated, high-voltage set of solar cells 206 combines first voltage 502 and second voltage 506 to provide third voltage 508 at high-voltage bus 212. Additionally, second electric current 604 flows from high-voltage set of solar cells 206 to high-voltage battery 218 to thereby charge high-voltage battery 218.

In various examples, portions of first electric current 602 can flow to different components in circuit 500. Therefore, high-voltage set of solar cells 206 can receive a first portion of first electric current 602. In some examples, a second portion of first electric current 602 can be selectively received by one or more of low-voltage battery 214 or low-voltage loads 216. This enables charging of low-voltage battery 214 and/or powering low-voltage loads 216 while also charging high-voltage battery 218. Additionally or alternatively, high resistance component 512 can receive a third portion of first electric current 602, such as when a rate of first electric current 602 is higher than a rate of electric current of high-voltage set of solar cells 206, for example. In such a manner, high resistance component 512 acts as a leakage current path and may help to protect high-voltage set of solar cells 206 and/or high-voltage battery 218 from excess electric current. In other examples, low-voltage battery 214 can provide some electric current to low-voltage bus 208. Additionally, in some examples, high-voltage battery 218 can receive a portion of second electric current 604, and high-voltage loads 220 can receive another portion of second electric current 604.

As previously mentioned, controller 222 can control switch 210 based upon electric charge of high-voltage battery 218. For example, when the electric charge of high-voltage battery 218 meets a charge threshold condition, controller 222 is configured to stop charging high-voltage battery 218 by controlling switch 210. FIG. 7 illustrates an example current diagram 700 when not charging high-voltage battery 218 in circuit 500. As can be seen, controller 222 controls switch 210 to break the electrical connection between low-voltage battery 214 and high-voltage set of solar cells 206. As such, high-voltage set of solar cells 206 is not receiving first electric current 702 from low-voltage set of solar cells 204. In such a configuration, high-voltage set of solar cells 206 is considered to have an open circuit. In some examples, an open circuit voltage of high-voltage set of solar cells 206 can be about Vb-Va voltage (e.g., a similar voltage range to second voltage 506 in FIGS. 5 and 6). Here, second diode 510 is reverse biased as high-voltage battery 218 provides third voltage 508 (Vb) to high-voltage bus 212. This helps to prevent reverse current flowing to high-voltage battery 218. Additionally, high resistance component 512 also helps to prevent a significant current from high-voltage set of solar cells 206. As a specific example, electric current may flow from high-voltage set of solar cells 206 to high-voltage battery 218 when the open circuit voltage of high-voltage set of solar cells 206 is not able to remain below third voltage 508, such as when a satellite comes out of eclipse, for example.

Optionally, second electric current 704 can flow from high-voltage battery 218 to high-voltage loads 220 to thereby power high-voltage loads 220. Alternatively or additionally, first electric current 702 can flow from low-voltage set of solar cells 204 to low-voltage battery 214 and/or low-voltage loads 216. In further examples, low-voltage battery 214 can power low-voltage loads 216 through low-voltage bus 208. Current diagram 600 and current diagram 700 are illustrative. In other examples, circuit 500 can have other current diagrams.

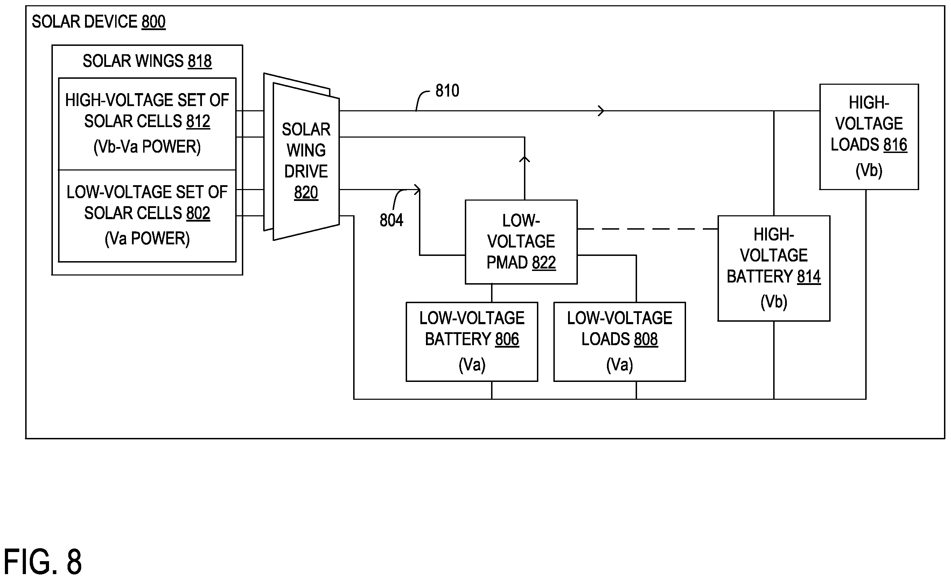

FIG. 8 depicts a block diagram of another example solar device 800. Similar to solar device 200, solar device 800 comprises a low-voltage set of solar cells 802, a low-voltage bus 804, a low-voltage battery 806, and low-voltage loads 808. Further, a high-voltage bus 810 is connected to a high-voltage set of solar cells 812, a high-voltage battery 814, and high-voltage loads 816. In the depicted example, solar device 800 comprises a plurality of solar arrays implemented in a plurality of solar wings 818. As depicted the plurality of solar wings 818 includes a low-voltage set of solar cells 802 and a high-voltage set of solar cells 812. A solar wing drive 820 is connected to the plurality of solar wings 818 to pass electrical connections while also rotating the plurality of solar wings 818, such as to track sunlight.

Solar device 800 further comprises a low-voltage PMAD (power management and distribution) 822 configured to manage electric power on solar device 800. PMAD 822 is configured to selectively connect low-voltage bus 804 to one or more of low-voltage battery 806, low-voltage loads 808, or an input of high-voltage set of solar cells 812, such as by using internal switches. PMAD 822 also receives information regarding electric charge of high-voltage battery 814 to help manage high-voltage bus 810 and/or high-voltage battery 814. PMAD 822 can connect low-voltage bus 804 to the input of high-voltage set of solar cells 812 when the electric charge of high-voltage battery 814 meets a low charge threshold condition. Further, PMAD 822 can break the connection to the input of high-voltage set of solar cells 812 to stop charging high-voltage battery 814 when the electric charge meets a voltage threshold condition. In some examples, PMAD 822 can also perform other controls on solar device 800, such as bus management and/or battery management, for example. Solar device 800 is one example of solar device 200. In other examples, a solar device can have another configuration.

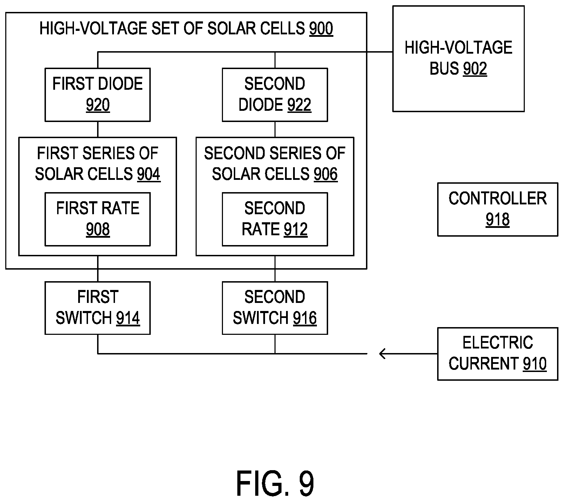

In the above examples, a high-voltage set of solar cells provides electric current with a single rate for a high-voltage bus. Alternatively, a high-voltage set of solar cells can be configured to provide additional rates of the electric current for the high-voltage bus. FIG. 9 shows a block diagram of such an example high-voltage set of solar cells 900. Here, a high-voltage bus 902 is connected to high-voltage set of solar cells 900. High-voltage bus 902 can be used for high-voltage bus 212 or high-voltage bus 810, for example. To provide multiple rates of the electric current, high-voltage set of solar cells 900 comprises a first series of solar cells 904 and a second series of solar cells 906 which are connected electrically in parallel. In other examples, more than two series of solar cells can be used in high-voltage set of solar cells 900. Such a configuration can help to provide a larger number of selectable current rates for high-voltage bus 902. As depicted, first series of solar cells 904 has a first rate 908 that allows a corresponding first portion of electric current 910 to flow through first series of solar cells 904. Further, second series of solar cells 906 has a second rate 912 that allows a corresponding second portion of electric current 910 to flow through second series of solar cells 906.

As first series of solar cells 904 and second series of solar cells 906 are electrically in parallel, high-voltage set of solar cells 900 can provide suitable combinations of first rate 908 and/or second rate 912 for high-voltage bus 902. As a specific example, first rate 908 can comprise 3 A (amperes) and second rate 912 can comprise 4 A. Therefore, high-voltage set of solar cells 900 can provide a set of rates of 0 A, 3 A, 4 A, or 7 A for high-voltage bus 902 in this example. In other examples, any other suitable rates can be provided. A first switch 914 is controllable to selectively direct the corresponding first portion of electric current 910 toward first series of solar cells 904. Additionally, a second switch 916 is controllable to direct the corresponding second portion of electric current 910 toward second series of solar cells 906. A controller 918 is configured to selectively control first switch 914 and/or second switch 916. As a specific example, controller 918 is configured to select a desired rate of the electric current for high-voltage bus 902 by selectively controlling first switch 914 to connect electric current 910 to first series of solar cells 904 and/or controlling second switch 916 to connect electric current 910 to second series of solar cells 906.

Additionally, a first diode 920 is configured to protect first series of solar cells 904 from possible reverse current, such as when first series of solar cells 904 are not illuminated. Similarly, a second diode 922 is configured to protect second series of solar cells 906 from possible reverse current. While depicted with two series of solar cells, a high-voltage set of solar cells can have more than two series of solar cells and corresponding components in other examples. FIG. 9 is illustrative. High-voltage set of solar cells 900 can have other configurations in other examples.

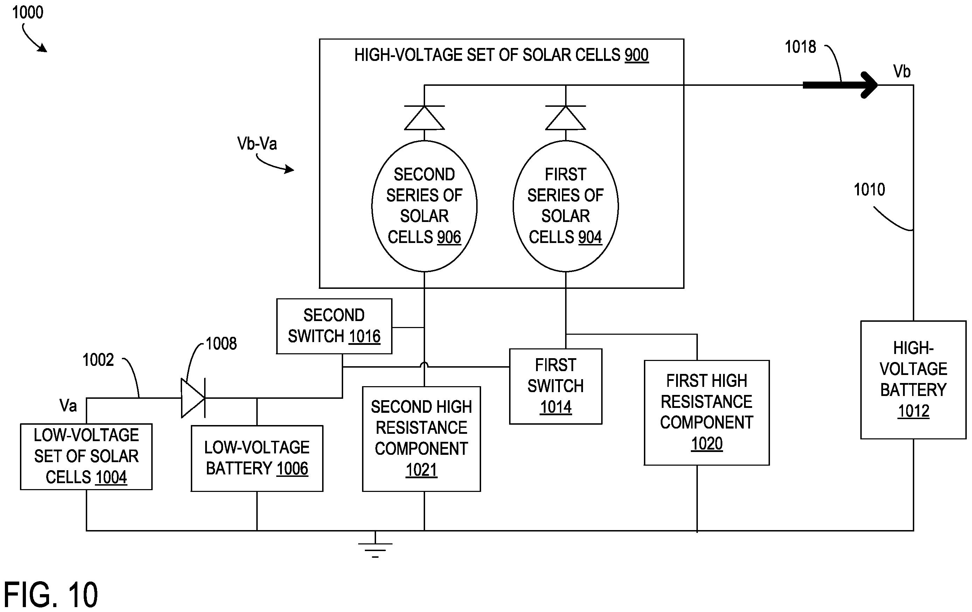

FIG. 10 schematically depicts an example circuit 1000 that utilizes high-voltage set of solar cells 900. Circuit 1000 can be used by solar device 200 or vehicle 100 for example. Similar to circuit 500, circuit 1000 comprises a low-voltage bus 1002 connected to a low-voltage set of solar cells 1004 and a low-voltage battery 1006. A first diode 1008 is connected between low-voltage set of solar cells 1004 and low-voltage battery 1006. Further, a high-voltage bus 1010 is connected to a high-voltage battery 1012.

Here, circuit 1000 comprises high-voltage set of solar cells 900 including first series of solar cells 904 configured to provide a first rate for the electric current for high-voltage bus 1010. High-voltage set of solar cells 900 also incudes second series of solar cells 906 configured to provide a second rate for the electric current for high-voltage bus 1010. Further, circuit 1000 comprises a first switch 1014 connected between low-voltage battery 1006 and first series of solar cells 904. Additionally, a second switch 1016 is connected between low-voltage battery 1006 and second series of solar cells 906. A controller can select a rate of electric current 1018 for high-voltage bus 1010 by controlling one or more of first switch 1014 or second switch 1016. Circuit 1000 also comprises a first high resistance component 1020 connected to first series of solar cells 904. High resistance component 1020 can help to prevent accidental charging of high-voltage battery 1012 and/or provide isolation of return nodes of first series of solar cells 904 in a similar manner as high resistance component 512 in circuit 500. Similarly, a second high resistance component 1021 is connected to second series of solar cells 906. Circuit 1000 is illustrative. In other examples, circuit 1000 can comprise other components not shown and/or have another configuration.

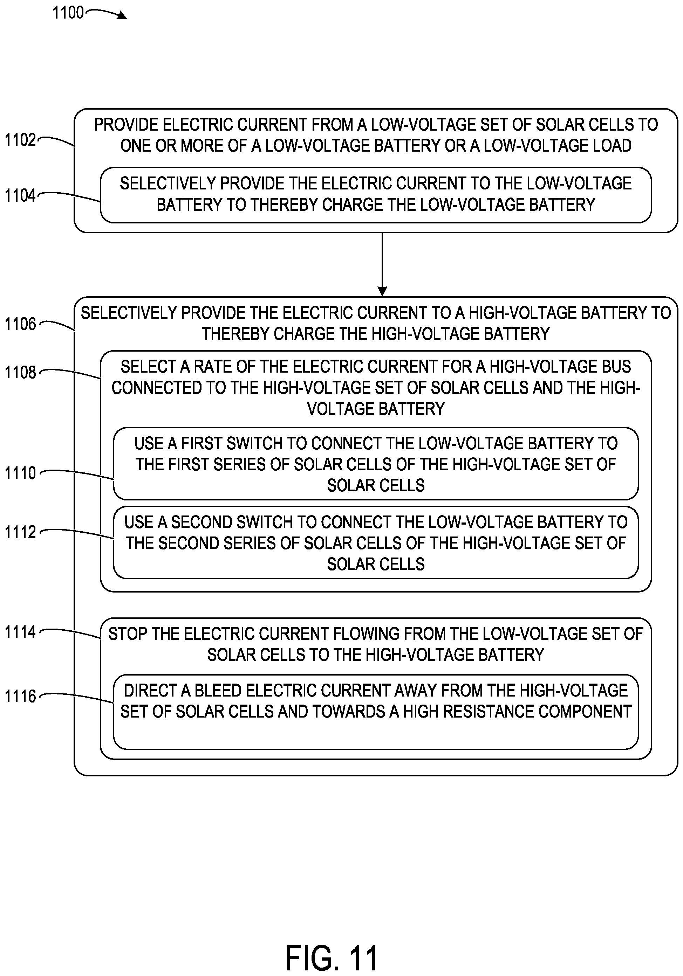

FIG. 11 illustrates a flow diagram of an example method 1100 for charging a high-voltage battery and a low-voltage battery on a solar device. Method 1100 can be performed by any suitable solar device, such as solar device 200 and vehicle 100, for example. The solar device also comprises one or more solar arrays including a low-voltage set of solar cells and a high-voltage set of solar cells. Method 1100 comprises, at 1102, providing electric current from the low-voltage set of solar cells to one or more of the low-voltage battery or a low-voltage load on the solar device. In some examples, providing the electric current from the low-voltage set of solar cells to one or more of the low-voltage battery or the low-voltage loads comprises selectively providing the electric current to the low-voltage battery to thereby charge the low-voltage battery, as indicated at 1104.

At 1106, method 1100 comprises selectively providing the electric current to the high-voltage battery to thereby charge the high-voltage battery by using a switch to connect the low-voltage battery to an input of the high-voltage set of solar cells. This connects the high-voltage set of solar cells electrically in series with the low-voltage set of solar cells. In such a configuration the high-voltage set of solar cells can provide the electric current to the high-voltage battery as discussed above. In some examples, selectively providing the electric current to the high-voltage battery comprises selecting a rate of the electric current for a high-voltage bus connected to the high-voltage set of solar cells and the high-voltage battery, as indicated at 1108. In such examples, the high-voltage set of solar cells includes a first series of solar cells and a second series of solar cells, such as in high-voltage set of solar cells 900, for example. Further, selecting the rate of the electric current for the high-voltage bus can comprise using a first switch to connect the low-voltage battery to the first series of solar cells of the high-voltage set of solar cells, as indicated at 1110. Additionally or alternatively, selecting the rate of the electric current for the high-voltage bus can comprise using a second switch to connect the low-voltage battery to the second series of solar cells of the high-voltage set of solar cells, as indicated at 1112. In such a manner, the rate of the electric current for the high-voltage bus can comprise any suitable combination of rates of the electric currents of the first series of solar cells and/or the second series of solar cells. This can help to manage powering various high-voltage loads and/or charging high-voltage battery on the solar device. In other examples, any suitable number of series of solar cells and corresponding switching can be used.

Method 1100 further comprises, at 1114, stopping the electric current flowing from the low-voltage set of solar cells to the high-voltage battery by using the switch to selectively disconnect the low-voltage battery from the high-voltage set of solar cells. Method 1100 also comprises, at 1116, directing a bleed electric current away from the high-voltage set of solar cells and towards a high resistance component when the switch is open. In the example of a satellite, the high-voltage set of solar cells can be cold upon eclipse exit and may result in unintentional charging of the high-voltage battery. In such a manner, the high resistance component can help to prevent the unintentional charging of the high-voltage battery. Further, the high resistance component can help to isolate a return node of the high-voltage set of solar cells from other return nodes on the solar device. In other examples, 1114 and/or 1116 can be omitted.

A solar device comprising a switch on a low-voltage bus to regulate a high-voltage bus as disclosed herein can help to enable simple control for regulating the high-voltage bus and/or lower a cost of the solar device compared to current solutions (e.g., integrated power controller). This can help to augment a less expensive solar device with high-voltage components without significant cost impacts.

Further, the disclosure comprises configurations according to the following clauses.

Clause 1. A solar device comprising: one or more solar arrays, the one or more solar arrays comprising a low-voltage set of solar cells and a high-voltage set of solar cells; a low-voltage bus connected to the low-voltage set of solar cells; a high-voltage bus connected to the high-voltage set of solar cells; a low-voltage battery connected to the low-voltage bus; a high-voltage battery connected to the high-voltage bus; and a switch connected between the low-voltage battery and an input of the high-voltage set of solar cells.

Clause 2. The solar device of clause 1, wherein the one or more solar arrays comprises a first solar array including the low-voltage set of solar cells, and a second solar array including the high-voltage set of solar cells.

Clause 3. The solar device of clause 1 or 2, wherein the one or more solar arrays comprises a solar array that is partitioned into the low-voltage set of solar cells and the high-voltage set of solar cells.

Clause 4. The solar device of any of clauses 1-3, further comprising a first diode electrically connected between the low-voltage set of solar cells and the low-voltage battery, and a second diode electrically connected between the high-voltage set of solar cells and the high-voltage battery.

Clause 5. The solar device of any of clauses 1-4, further comprising a high resistance component electrically connected to the high-voltage set of solar cells such that the high resistance component is electrically in parallel to the low-voltage battery.

Clause 6. The solar device of any of clauses 1-5, wherein the high-voltage set of solar cells comprises a first series of solar cells configured to provide a first rate of the electric current to the high-voltage bus, and a second series of solar cells configured to provide a second rate of the electric current to the high-voltage bus, and the switch is a first switch connected between the low-voltage battery and the first series of solar cells; and further comprising a second switch connected between the low-voltage battery and the high-voltage set of solar cells.

Clause 7. The solar device of any of clauses 1-6, wherein the solar device is a satellite.

Clause 8. The solar device of any of clauses 1-7, further comprising a controller configured to control the switch based at least upon electric charge of the high-voltage battery.

Clause 9. A solar device comprising: one or more solar arrays, the one or more solar arrays comprising a low-voltage set of solar cells and a high-voltage set of solar cells; a low-voltage bus connected to the low-voltage set of solar cells; a high-voltage bus connected to the high-voltage set of solar cells; a low-voltage battery connected to the low-voltage bus; a high-voltage battery connected to the high-voltage bus; a switch connected between the low-voltage battery and an input of the high-voltage set of solar cells; and a controller configured to control the switch based at least upon electric charge of the high-voltage battery.

Clause 10. The solar device of clause 9, wherein the one or more solar arrays comprises a first solar array comprising the low-voltage set of solar cells, and a second solar array comprising the high-voltage set of solar cells.

Clause 11. The solar device of clause 9 or 10, wherein the one or more solar arrays comprises a solar array that is partitioned into the low-voltage set of solar cells and the high-voltage set of solar cells.

Clause 12. The solar device of any of clauses 9-11, further comprising a first diode electrically connected between the low-voltage set of solar cells and the low-voltage battery, and a second diode electrically connected between the high-voltage set of solar cells and the high-voltage battery.

Clause 13. The solar device of any of clauses 9-12, further comprising a high resistance component electrically connected to the high-voltage set of solar cells such that the high resistance component is electrically in parallel to the low-voltage battery.

Clause 14. The solar device of any of clauses 9-13, wherein the high-voltage set of solar cells comprises a first series of solar cells configured to provide a first rate of the electric current to the high-voltage bus, and a second series of solar cells configured to provide a second rate of the electric current to the high-voltage bus, and the switch is a first switch connected between the low-voltage battery and the first series of solar cells; and further comprising a second switch connected between the low-voltage battery and the second series of solar cells; and wherein the controller is further configured to selectively control one or more of the first switch or the second switch.

Clause 15. The solar device of any of clauses 9-14, wherein the solar device is a satellite.

Clause 16. A method for charging one or more of a low-voltage battery or a high-voltage battery on a solar device comprising one or more solar arrays, the one or more solar arrays comprising a low-voltage set of solar cells connected to the low-voltage battery, and a high-voltage set of solar cells connected to the high-voltage battery, the method comprising: providing electric current from the low-voltage set of solar cells to one or more of the low-voltage battery or a low-voltage load on the solar device; and selectively providing the electric current to the high-voltage battery to thereby charge the high-voltage battery by using a switch to connect the low-voltage battery to an input of the high-voltage set of solar cells.

Clause 17. The method of clause 16, further comprising stopping the electric current flowing from the low-voltage set of solar cells to the high-voltage battery by using the switch to selectively disconnect the low-voltage battery from the high-voltage set of solar cells.

Clause 18. The method of clause 17, further comprising directing a bleed electric current away from the high-voltage set of solar cells and towards a high resistance component.

Clause 19. The method of any of clauses 16-18, wherein providing the electric current from the low-voltage set of solar cells to one or more of the low-voltage battery or the low-voltage loads comprises selectively providing the electric current to the low-voltage battery to thereby charge the low-voltage battery.

Clause 20. The method of any of clauses 16-19, wherein selectively providing the electric current to the high-voltage battery comprises selecting a rate of the electric current for a high-voltage bus connected to the high-voltage battery by one or more of using a first switch to connect the low-voltage battery to a first series of solar cells of the high-voltage set of solar cells, or using a second switch to connect the low-voltage battery to a second series of solar cells of the high-voltage set of solar cells.

It will be understood that the configurations and/or approaches described herein are exemplary in nature, and that these specific embodiments or examples are not to be considered in a limiting sense, because numerous variations are possible. The specific routines or methods described herein may represent one or more of any number of processing strategies. As such, various acts illustrated and/or described may be performed in the sequence illustrated and/or described, in other sequences, in parallel, or omitted. Likewise, the order of the above-described processes may be changed.

The subject matter of the present disclosure includes all novel and non-obvious combinations and sub-combinations of the various processes, systems and configurations, and other features, functions, acts, and/or properties disclosed herein, as well as any and all equivalents thereof.

### Parts List:

vehicle 100
low-voltage battery 102, 214, 806, 1006
first solar array 104, 300
low-voltage set of solar cells 106, 204, 802, 1004
second solar array 108, 302
high-voltage set of solar cells 110, 206, 812, 900
switch 112, 210
high-voltage battery 114, 218, 814, 1012
solar device 200, 800
solar arrays 202, 400
low-voltage bus 208, 804, 1002
high-voltage bus 212, 810, 902, 1010
low-voltage loads 216, 808
high-voltage loads 220, 816
controller 222, 918
circuit 500
first voltage 502
first diode 504, 1008
second voltage 506
third voltage 508
second diode 510
high resistance component 512
electric ground 514
current diagram 600
first electric current 602, 702, 910
second electric current 604, 704, 1018
current diagram 700
solar wings 818
solar wing drive 820
PMAD 822
first series of solar cells 904
second series of solar cells 906
first rate 908
second rate 912
first switch 914, 1014
second switch 916, 1016
first diode 920
second diode 922
circuit 1000
first high resistance component 1020
second high resistance component 1021
method 1100
steps 1102, 1104, 1106, 1108, 1110, 1112 1114, 1116

## Claims

1. A solar device (200, 800) comprising:
one or more solar arrays (202), the one or more solar arrays (202) comprising a low-voltage set of solar cells (106, 204, 802, 1004) and a high-voltage set of solar cells (110, 206, 812, 900);
a low-voltage bus (208, 804, 1002) connected to the low-voltage set of solar cells (106, 204, 802, 1004);
a high-voltage bus (212, 810, 902, 1010) connected to the high-voltage set of solar cells (110, 206, 812, 900);
a low-voltage battery (102, 214, 806, 1006) connected to the low-voltage bus (208, 804, 1002);
a high-voltage battery (114, 218, 814, 1012) connected to the high-voltage bus (212, 810, 902, 1010); and
a switch (112, 210) connected between the low-voltage battery (102, 214, 806, 1006) and an input of the high-voltage set of solar cells (110, 206, 812, 900).

2. The solar device (200, 800) of claim 1, wherein the one or more solar arrays (202) comprises a first solar array (104, 300) including the low-voltage set of solar cells (106, 204, 802, 1004), and a second solar array (108, 302) including the high-voltage set of solar cells (110, 206, 812, 900).

3. The solar device (200, 800) of claim 1 or 2, wherein the one or more solar arrays (202) comprises a solar array (400) that is partitioned into the low-voltage set of solar cells (106, 204, 802, 1004) and the high-voltage set of solar cells (110, 206, 812, 900).

4. The solar device (200, 800) of any preceding claim, further comprising
a first diode (504, 1008) electrically connected between the low-voltage set of solar cells (106, 204, 802, 1004) and the low-voltage battery (102, 214, 806, 1006), and
a second diode (510) electrically connected between the high-voltage set of solar cells (110, 206, 812, 900) and the high-voltage battery (114, 218, 814, 1012).

5. The solar device (200, 800) of any preceding claim, further comprising a high resistance component (512) electrically connected to the high-voltage set of solar cells (110, 206, 812, 900) such that the high resistance component (512) is electrically in parallel to the low-voltage battery (102, 214, 806, 1006).

6. The solar device (200, 800) of any preceding claim, wherein
the high-voltage set of solar cells (110, 206, 812, 900) comprises
a first series of solar cells (904) configured to provide a first rate (908) of the electric current to the high-voltage bus (212, 810, 902, 1010), and
a second series of solar cells (906) configured to provide a second rate (912) of the electric current to the high-voltage bus (212, 810, 902, 1010), and
the switch (112, 210) is a first switch (914, 1014) connected between the low-voltage battery (102, 214, 806, 1006) and the first series of solar cells (904); and
further comprising a second switch (916, 1016) connected between the low-voltage battery (102, 214, 806, 1006) and the high-voltage set of solar cells (110, 206, 812, 900).

7. The solar device (200, 800) of any preceding claim, further comprising a controller (222, 918) configured to control the switch (112, 210) based at least upon electric charge of the high-voltage battery (114, 218, 814, 1012).

8. A solar device (200, 800) of any preceding claim further comprising
a controller (222, 918) configured to control the switch (112, 210) based at least upon electric charge of the high-voltage battery (114, 218, 814, 1012).

9. The solar device (200, 800) of any preceding claim, wherein the solar device (200, 800) is a satellite.

10. The solar device (200, 800) of any preceding claim, wherein the one or more solar arrays (202) are implemented in one or more solar wings (818).

11. A method (1100) for charging one or more of a low-voltage battery (102, 214, 806, 1006) or a high-voltage battery (114, 218, 814, 1012) on a solar device (200, 800) comprising one or more solar arrays (202), the one or more solar arrays (202) comprising a low-voltage set of solar cells (106, 204, 802, 1004) connected to the low-voltage battery (102, 214, 806, 1006), and a high-voltage set of solar cells (110, 206, 812, 900) connected to the high-voltage battery (114, 218, 814, 1012), the method (1100) comprising:
providing electric current from the low-voltage set of solar cells to one or more of the low-voltage battery or a low-voltage load on the solar device (1102); and
selectively providing the electric current to the high-voltage battery to thereby charge the high-voltage battery by using a switch to connect the low-voltage battery to an input of the high-voltage set of solar cells (1106).

12. The method (1100) of claim 11, further comprising stopping the electric current flowing from the low-voltage set of solar cells to the high-voltage battery by using the switch to selectively disconnect the low-voltage battery from the high-voltage set of solar cells (1114).

13. The method (1100) of claim 11 or 12, further comprising directing a bleed electric current away from the high-voltage set of solar cells and towards a high resistance component (1116).

14. The method (1100) of any of claims 11 to 13, wherein providing the electric current from the low-voltage set of solar cells to one or more of the low-voltage battery or the low-voltage loads (1102) comprises selectively providing the electric current to the low-voltage battery to thereby charge the low-voltage battery (1104).

15. The method (1100) of any of claims 11 to 14, wherein selectively providing the electric current to the high-voltage battery (1106) comprises selecting a rate of the electric current for a high-voltage bus connected to the high-voltage battery (1108) by one or more of
using a first switch to connect the low-voltage battery to a first series of solar cells of the high-voltage set of solar cells (1110), or
using a second switch to connect the low-voltage battery to a second series of solar cells of the high-voltage set of solar cells (1112).
